# EUROPEAN PATENT APPLICATION

(11) **EP 2 381 498 A1**
(43) Date of publication of application: **26.10.2011**
(21) Application number: 10382089.0
(22) Date of filing: 20.04.2010
(51) Int. Cl.: H01L 35/32, H01L 23/38

(54) **Method for manufacturing a thermoelectric module, and thermoelectric module**

(71) Applicant: Mondragon Componentes, S. Coop., 20550 Aretxabaleta (ES)
(72) Inventor: García Ramos, Gustavo, 01010, Vitoria-Gasteiz (ES); Aranceta Aguirre, Francisco Javier, 48220, Abadiño (ES); Borda Camino, José Javier, 20008, Donostia-San Sebastian (ES); Barbero Merino, Antonio José, 20500 Mondragon (Gipuzkoa) (ES)
(74) Representative: Igartua, Ismael

(57) **Abstract**

Method for manufacturing a thermoelectric module, wherein a plurality of thermoelectric elements (7) are arranged on an electrically conductive substrate (11), and said thermoelectric elements (7) are connected to said conductive substrate (11). The conductive substrate (11) forms part of a printed circuit (10), said printed circuit (10) comprising said conductive substrate (11), a metallic substrate (12) and a dielectric substrate (13) arranged between the metallic substrate (12) and the conductive substrate (11) in order to electrically insulate said conductive and metallic substrates (11, 12) from each other. Said conductive substrate (11) comprises a certain structure, so that when the thermoelectric elements (7) are arranged on said conductive substrate (11) a required electric conduction is generated.

## Description

### TECHNICAL FIELD

The present invention relates to methods for manufacturing thermoelectric modules, and to the thermoelectric modules obtained by means of said methods, which are used to refrigerate an object, or to obtain an electrical current from a difference in temperature between two objects.

### PRIOR ART

Thermoelectric modules are widely known in the prior art and are used largely to transmit heat from an object or surface to another object (refrigeration) by applying an electrical current to an electric conduction (Peltier effect), although they may also be used to obtain an electrical current from a difference in temperature between two objects (Seebeck effect).

Generally speaking, the modules comprise an electrically conductive substrate, preferably copper, and a support substrate, generally alumina or another type of ceramic material. On said conductive substrate arrangea plurality of N- and P-type thermoelectric elements are arranged in an alternate manner. The copper comprises a structure that corresponds with a required electric conduction for said module.

The drawback with using alumina or another type of ceramic material is that the module cannot be easily and quickly connected to the surface of the object to be refrigerated or from which the difference in temperature is to be obtained, as excessive tightening may cause the alumina and therefore the module to break. Similarly, the size of the module is restricted because the structure of the alumina cannot support large modules.

Document US5040381 discloses a module that discloses a support substrate that can comprise aluminium or copper instead of alumina, thereby resolving the aforementioned drawbacks. The module disclosed in said document is obtained by disposing, in a laminated manner, a dielectric substrate on the support substrate, with a copper plate of a certain thickness being arranged on said dielectric substrate, and thermoelectric elements being arranged on said copper plate.

### DISCLOSURE OF THE INVENTION

It is an object of the invention to provide a method for manufacturing a thermoelectric module, and a thermoelectric module manufactured with said method, as described in the claims.

In the method for manufacturing a thermoelectric module of the invention, a plurality of thermoelectric elements are arranged on an electrically conductive substrate, and said thermoelectric elements are connected to said conductive substrate. The conductive substrate forms part of a printed circuit, said printed circuit comprising said conductive substrate, a metallic substrate and a dielectric substrate arranged between the metallic substrate and the conductive substrate, the purpose being to insulate said conductive and metallic substrates electrically from each other.

The conductive substrate comprises a certain structure for the purposes of obtaining, together with the thermoelectric elements, a required electric conduction.

The method of the invention enables the manufacture of thermoelectric modules from a printed circuit, thereby reducing the cost and time involved in manufacturing the module, and even making said manufacture far more flexible as the required circuit may be designed in a simple and quick manner, which can be especially advantageous in testing new designs or prototypes for their subsequent mass manufacture, for example.

These and other advantages and characteristics of the invention will be made evident in the light of the drawings and the detailed description thereof.

### DESCRIPTION OF THE DRAWINGS

Figure 1 shows an embodiment of the thermoelectric module of the invention.
Figure 2 shows the thermoelectric module of Figure 1 and its electric conduction.
Figure 3 is a ground view of a structure of a conductive substrate of the thermoelectric module of Figure 1, arranged on a dielectric substrate of said module.
Figure 4 shows a thermoelectric module according to the invention, formed by two units.
Figure 5 shows a thermoelectric module according to the invention, with electronic circuitry arranged on it.
Figure 6 shows a thermoelectric module according to the invention, with an electronic circuitry.

### DETAILED DISCLOSURE OF THE INVENTION

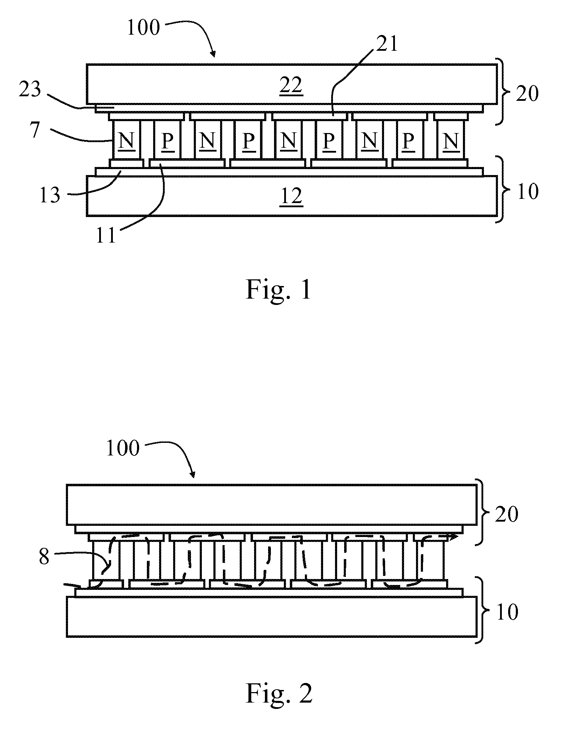

In the method of the invention, for manufacturing a thermoelectric module 100, a plurality of thermoelectric elements 7 are arranged on an electrically conductive substrate 11, preferably copper, and said thermoelectric elements 7 are connected to said conductive substrate 11 by means of conventional soldering, for example. With reference to Figures 1 and 2, the conductive substrate 11 forms part of a printed circuit 10, said printed circuit 10 comprising said conductive substrate 11, a metallic substrate 12 and a dielectric substrate 13 that is arranged between the metallic substrate 12 and the conductive substrate 11 and which preferably corresponds with a commercial epoxy or resin, such as the one known as Thermal CLAD®, said conductive substrate 11 being electrically insulated from said metallic substrate 12.

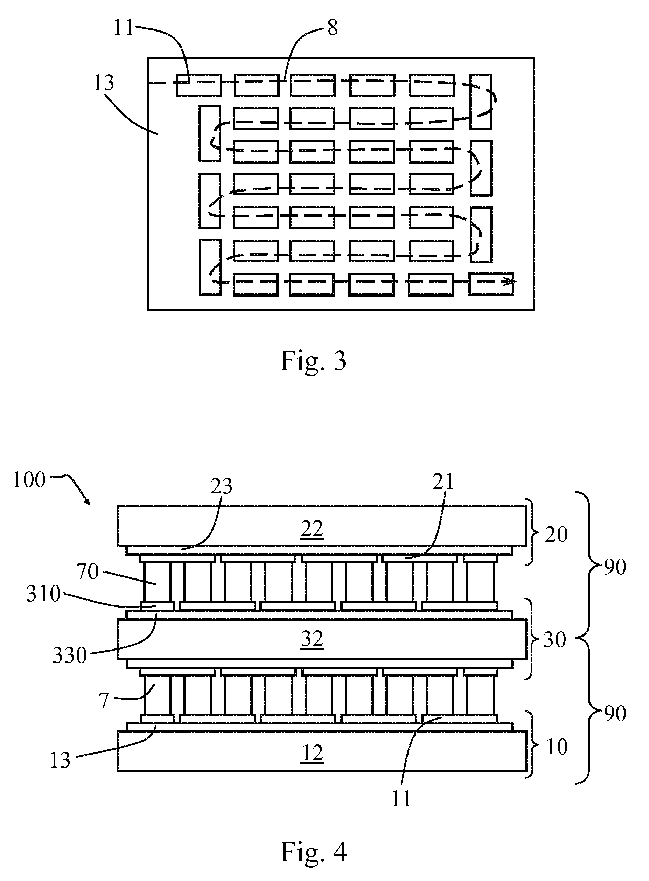

The conductive substrate 11 comprises a certain structure such as the one shown for example in Figure 3, the purpose being to obtain, together with the thermoelectric elements 7, a required electric conduction 8. The thermoelectric elements 7 are of the N- and P-type, being arranged in an alternate manner as shown in Figure 1. The electric conduction 8 is not explained because it is not the object of the invention, and is known in the prior art.

Generally speaking, the printed circuits comprise at least three substrates: a substrate that is generally fibre glass, a conductive substrate that is generally copper, and a dielectric substrate arranged between the fibre glass and the conductive substrate and which also ensures that said conductive substrate adheres or fixes to the fibre glass. In the method of the invention a printed circuit 10 is used which, rather than a fibreglass substrate, comprises a metallic substrate, preferably aluminium, although it can be made of another metal provided that it has, preferably, a thermal conductivity greater than the thermal conductivity of the alumina. A metal with a lower thermal conductivity can be used although the performance and/or the efficiency of the module 100 would be greatly reduced in this case, making the use of said modules 100 unprofitable. As a result, said module 100 can be fixed to an object in a simple and quick manner as the strength provided by the aluminium means that it can be handled without fear of it breaking, as is the case when handling alumina. In addition, the structure of the aluminium, due to its strength, does not prevent the manufacture of a large module 100. Furthermore, the aluminium enables a quick and homogenous diffusion of heat, a more efficient module 100 thereby being achieved.

In a first embodiment of the method of the invention, the required structure of the conductive substrate 11 is achieved by removing part of said conductive substrate 11 from said printed circuit 10 prior to the disposal of the thermoelectric elements 7 on it. The conductive substrate 11 can be removed by using any known method, although any technique used in the manufacture of printed circuits (mechanical, chemical, laser, etc) is used. The thermoelectric elements 7, for their own, are arranged on said conductive substrate 11, preferably by also using any technique used in the manufacture of electronic circuits, such as pick-and-place machines. Said thermoelectric elements 7 can thus be fixed to the conductive substrate 11 by means of conventional soldering, the module being introduced in an oven or equivalent appliance not shown in the figures.

In a second embodiment of the method of the invention, when manufacturing the corresponding printed circuit 10, rather than a conductive substrate 1 being arranged on the entire surface of the metallic substrate 2, with the excess subsequently being removed, only the structure of said required conductive substrate 1 is arranged. It is sufficient therefore to arrange the thermoelectric elements 7 on said conductive substrate 1 without having to carry out any additional operation, such as removing part of said conductive substrate 1.

With the method of the invention, a module 100 can be manufactured in a simple and quick manner. Using a printed circuit 10 the required structure of the conductive substrate 11 can be achieved quickly and using known techniques, the operation (or operations) whereby the substrates 11, 12 and 13 (the three already included in the printed circuit 10) are arranged being the most complex and the most time-consuming. The method of the invention thus enables the more flexible manufacture of thermoelectric modules 100, thereby facilitating the design and use of prototypes in a quick and simple manner, for example. In addition, with the method of the invention a very compact module 100 can be obtained, given that different thermoelectric elements 7 can be arranged very close to each other, due to the ease with which the required shape of the conductive substrate 11 is obtained. Another advantage of using the method of the invention is the ease with which modules 100 with different arrangements can be obtained due to the fact that thermoelectric elements 7 of different sizes and/or shapes can be arranged in a single module 100, in a very simple way.

Preferably, in the method of the invention a second printed circuit 20 can also be arranged on the thermoelectric elements 7, the second printed circuit 20 comprising a metallic substrate 22, an electrically conductive substrate 21, preferably copper, and a dielectric substrate 23 that is arranged between the metallic substrate 22 and the conductive substrate 21 and which preferably corresponds with a commercial epoxy or resin, such as the one known as Thermal CLAD®, said conductive substrate 21 being arranged on the thermoelectric elements 7, so that said thermoelectric elements 7 are arranged between the conductive substrates 11 and 21 of both printed circuits 10 and 20 like a sandwich, and thanks to said conductive substrate 21 the required electric conduction 8 is closed, as shown in Figure 2. The two printed circuits 10 and 20, together with the thermoelectric elements 7, form a modular unit 90 that, in the embodiment of Figures 1 and 2, corresponds with a thermoelectric module 100.

In an embodiment of the module 100 of the invention, a printed circuit 30 of said module 100 can comprise an additional electrically conductive substrate 310, preferably copper, and an additional dielectric substrate 330 arranged between said additional conductor 310 and the metallic substrate 32 corresponding to said printed circuit 30. Hereinafter, for comprehension purposes, a printed circuit comprising two conductive substrates is identified as a double printed circuit, whereas a formed printed circuit comprising a single conductive substrate is identified as a single printed circuit.

In an embodiment of the module 100 of the invention, shown in Figure 4, said module 100 comprises two single printed circuits 10 and 20 and a double printed circuit 30. The additional conductive substrate 310 is used to form an additional modular unit 90, a plurality of thermoelectric elements 70 being arranged on said additional conductive substrate 310. A second printed circuit 20 is arranged on said additional thermoelectric elements 70, said second printed circuit 20 comprising a metallic substrate 22, an electrically conductive substrate 21, and a dielectric substrate 23 arranged between the metallic substrate 22 and the conductive substrate 21, said conductive substrate 21 being arranged on the additional thermoelectric elements 70, so that said additional thermoelectric elements 70 are arranged between the conductive substrates 310 and 21 of both printed circuits 20 and 30 like a sandwich. As a result, the module 100 of the embodiment of Figure 4 comprises two modular units 90, although the module 100 of the invention can comprise as many modular units 90 as required. Each modular unit 90 comprises a single printed circuit, a double printed circuit and a plurality of thermoelectric elements arranged between both printed circuits (provided that the module has more than one modular unit 90). It is clear that two adjacent modular units 90 share a common printed circuit that corresponds with a double printed circuit. This can be achieved thanks to the use of printed circuits in order to generate the module 100, thereby simplifying and enabling the fabrication of the modules 100 as well as providing the necessary strength to support different modular units 90.

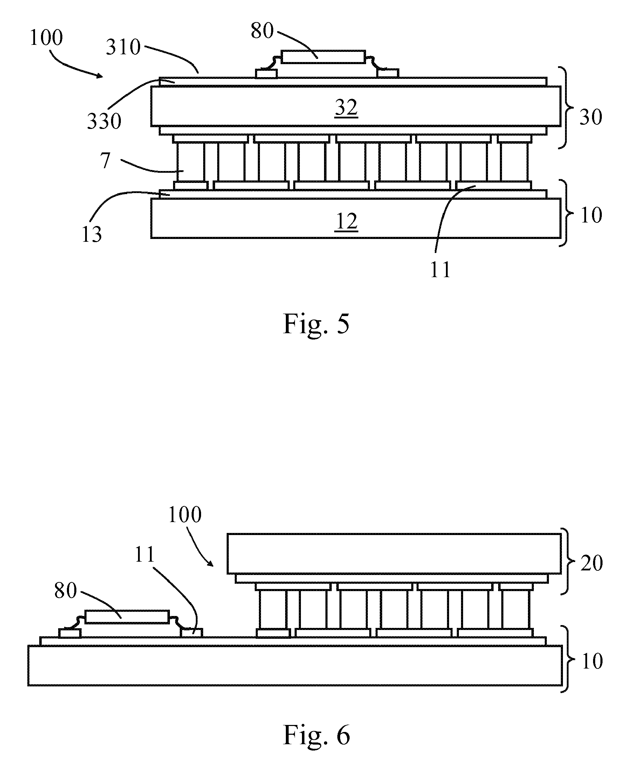

In the embodiment in Figure 5, an electronic circuitry 80 is arranged on the additional conductive substrate 210 so that said electronic circuitry 80 can be arranged on the module 100 of the invention and said electronic circuitry 80 can be refrigerated in a very direct and efficient manner. This arrangement can be achieved regardless of the number of modular units 90 that make up the module 100.

In another embodiment of the invention, shown in Figure 6, at least one of the printed circuits 10 of the module of the invention can comprise a greater width or length than that necessary for the module 100, so that electronic circuitry 80 can be arranged in said additional width or length. An advantage of this embodiment is the use of the module 100 to generate the Seebeck effect, so that the energy generated can be used to supply the electronic circuitry 80. In addition, as said electronic circuitry 80 is arranged on the same metallic substrate 12 as the module 100, said electronic circuitry 80 can make use of the temperature transfer qualities of the module 100 to ensure it does not refrigerate or heat excessively.

An additional advantage of the module 100 of the embodiments incorporating electronic circuitry 80 is that both said electronic circuitry 80 and the elements of said module 100 can be connected to each other or soldered at the same time, in a single operation, by means of an oven or an equivalent appliance, thus making the assembly process easier. Furthermore, the module 100 and the electronic circuitry 80 form a single compact and indivisible element.

## Claims

1. Method for manufacturing a thermoelectric module, wherein
a plurality of thermoelectric elements (7) are arranged on an electrically conductive substrate (11), and said thermoelectric elements (7) are connected to said conductive substrate (11),
**characterised in that**
the conductive substrate (11) forms part of a printed circuit (10), said printed circuit (10) comprising said conductive substrate (11), a metallic substrate (12), and a dielectric substrate (13) arranged between the metallic substrate (12) and the conductive substrate (11) in order to electrically insulate said conductive and metallic substrates (11, 12) from each other, and
said conductive substrate (11) comprising a certain structure, for the purposes of obtaining, together with the thermoelectric elements (7), a required electric conduction (8).

2. Method according to claim 1, wherein the certain structure of the conductive substrate (11) is achieved by removing at least part of said conductive substrate (11) from the printed circuit (10) before the thermoelectric elements (7) are arranged on it.

3. Method according to claim 1 or 2, wherein a second printed circuit (20) is arranged on the thermoelectric elements (7), the second printed circuit (20) comprising a metallic substrate (22), an electrically conductive substrate (21), and a dielectric substrate (23) arranged between the metallic substrate (22) and the conductive substrate (21), said conductive substrate (21) being arranged on the thermoelectric elements (7) arranged on the conductive substrate (11) of the printed circuit (10), so that said thermoelectric elements (7) are arranged between the conductive substrates (11, 21) of both printed circuits (10, 20) like a sandwich.

4. Method according to claim 3, wherein at least one of the printed circuits (10, 20) comprises an additional electrically conductive substrate (210) and an additional dielectric substrate (230) arranged between said additional conductive substrate (210) and the corresponding metallic substrate (22), a plurality of additional thermoelectric elements (70) being arranged on said additional conductive substrate (210).

5. Method according to claim 4, wherein a third printed circuit (30) is arranged on the additional thermoelectric elements (70), which comprises a metallic substrate (32), an electrically conductive substrate (31) and a dielectric substrate (33) arranged between the metallic substrate (32) and the conductive substrate (31), said conductive substrate (31) being arranged on the additional thermoelectric elements (70), so that said additional thermoelectric elements (70) are arranged between the conductive substrates (210, 31) of both printed circuits (20, 30) like a sandwich.

6. Thermoelectric module that comprises
a metallic substrate (12),
an electrically conductive substrate (11),
a dielectric substrate (13) arranged between the metallic substrate (12) and the conductive substrate (11), and
a plurality of thermoelectric elements (7) arranged on the conductive substrate (11),
**characterised in that**
the conductive substrate (11) comprises a certain structure, for the purposes of obtaining, together with the thermoelectric elements (7), a required electric conduction (8), and
the metallic substrate (12), said conductive substrate (11) and the dielectric substrate (13) correspond with a printed circuit (10).

7. Module according to claim 6, comprising a second printed circuit (20; 30) with a metallic substrate (22; 32), a conductive substrate (21; 31) and a dielectric substrate (23; 33) arranged between the metallic substrate (22; 32) and the conductive substrate (21; 31), the conductive substrates (11, 21; 11, 31) of each printed circuit (10, 20; 10, 30) facing each other and the thermoelectric elements (7) being arranged between both printed circuits (10, 20; 10, 30) like a sandwich.

8. Module according to claim 7, wherein at least one printed circuit (30) comprises an additional electrically conductive substrate (310) opposite to the conductive substrate (31), and a dielectric substrate (33) arranged between the metallic substrate (32) and the additional conductive substrate (310).

9. Module according to claim 8, comprising at least two modular units (90), each of them formed by a plurality of thermoelectric elements (7, 70) arranged between two printed circuits (10, 30; 20 30), said two adjacent modular units (90) comprising a common printed circuit (30), and said common printed circuit (30) comprising a conductive substrate (31) and a dielectric substrate (33).

10. Module according to claim 8 or 9, wherein the additional conductive substrate (310) is copper.

11. Module according to any of claims 8 to 10, wherein the additional dielectric substrate (330) is an epoxy or resin.

12. Module according to any of claims 6 to 11, wherein the conductive substrate (11, 21, 31) is copper.

13. Module according to any of claims 6 to 12, wherein the dielectric substrate (13, 23, 33) is an epoxy or resin.

14. Module according to any of claims 5 to 11, wherein the metallic substrate (12, 22, 32) is aluminium.
